# EUROPEAN PATENT APPLICATION

(11) **EP 4 254 508 A1**
(43) Date of publication of application: **04.10.2023**
(21) Application number: 21896387.4
(22) Date of filing: 30.07.2021
(51) Int. Cl.: H01L 29/78, H01L 21/336

(54) **SEMICONDUCTOR DEVICE AND MANUFACTURING METHOD THEREFOR**

(30) Priority: 27.11.2020 CN 202011357357
(71) Applicant: Gree Electric Appliances, Inc. of Zhuhai, Zhuhai, Guangdong 519070 (CN)
(72) Inventor: LIN, Yiren, Zhuhai, Guangdong 519070 (CN); SHI, Bo, Zhuhai, Guangdong 519070 (CN); CHEN, Daokun, Zhuhai, Guangdong 519070 (CN); ZENG, Dan, Zhuhai, Guangdong 519070 (CN)
(74) Representative: Murgitroyd & Company
(86) International application number: PCT/CN2021/109847
(87) International publication number: WO 2022/110880

(57) **Abstract**

The disclosure relates to the technical field of semiconductors, in particular to a semiconductor device and a manufacturing method therefor. The semiconductor device includes a semiconductor substrate, an epitaxial layer grown on a side of the semiconductor substrate; a quantum dot transport layer formed on the epitaxial layer; and a gate oxide layer formed on the quantum dot transport layer. With this arrangement, the semiconductor device provided by the present disclosure may reduce a threshold voltage while ensuring gate electrode reliability.

## Description

### CROSS-REFERENCE TO RELATED APPLICATIONS

This application claims priority to Chinese Patent Application No. 202011357357.7, filed on November 27, 2020, entitled "semiconductor device and manufacturing method therefor".

### TECHNICAL FIELD

The present application relates to the field of semiconductor technology, and in particular, to a semiconductor device and a manufacturing method therefor.

### BACKGROUND

Semiconductor technology plays a decisive role in the development of electronic industry. Therein, a power semiconductor device is regarded as a key component of a power electronic equipment. The rapid development in SiC Metal-Oxide Semiconductor Field-Effect Transistor (SiC MOSFET) aroused a wide attention to this new generation of power devices. SiC MOSFET has advantages of low specific on-resistance, high operating frequency and stability at high temperature, and has a very broad application prospect in the field of power devices.

One of technical difficulties of SiC MOSFET is to reduce a threshold voltage (Vth) and channel gate resistance to improve electron mobility in channel.

In the prior art, the most straightforward way to reduce the Vth is to reduce a thickness of gate oxide, but the gate oxide is extremely fragile and reduction in the thickness may lead to a risk of reduction in gate reliability.

How to reduce the Vth while ensuring the gate reliability has become an important technical problem to be solved by those skilled in the art.

### SUMMARY

In order to solve the problem that there would be a reduction in gate electrode reliability as lowering a threshold voltage (Vth) by reducing a thickness of gate oxide. The present disclosure provides a semiconductor device to reduce the Vth while ensuring the gate electrode reliability. The disclosure also provides a manufacturing method for said semiconductor device.

According to a first aspect, the present disclosure provides a semiconductor device including:
a semiconductor substrate, where an epitaxial layer is grown on a surface of the semiconductor substrate;
a quantum dot transport layer formed on the epitaxial layer; and
a gate oxide layer formed on the quantum dot transport layer.

Optionally, material of the quantum dot transport layer includes GaN.

Optionally, a structure of the quantum dot transport layer is a nanowire structure.

Optionally, the semiconductor substrate includes an N-type SiC substrate.

Optionally, the semiconductor device further includes a carrier transport layer formed between the quantum dot transport layer and the epitaxial layer.

Optionally, a lattice matching degree between the carrier transport layer and the semiconductor substrate is greater than a preset matching degree.

Optionally, material of the semiconductor substrate includes SiC, and material of the carrier transport layer includes: MoS₂, BN, Bi₂Te₃ or Bi₂Se₃.

Optionally, the carrier transport layer is a plane film layer and a thickness of the planar film layer ranges from 1nm to 50 nm.

Optionally, the semiconductor device further includes a metal layer formed on a side of the semiconductor substrate away from the epitaxial layer and a metal layer formed on an outer side of the gate oxide layer.

According to another aspect, the present disclosure provides a manufacturing method for a semiconductor device including:
forming a semiconductor substrate with an epitaxial layer by an epitaxial growth process;
depositing a quantum dot transport layer on the epitaxial layer; and
thermally growing a gate oxide layer on the quantum dot transport layer.

Optionally, the depositing a quantum dot transport layer on the epitaxial layer includes: depositing the quantum dot transport layer at a temperature ranging from 500°C to 700°C by metal organic chemical vapor deposition (MOCVD).

Optionally, the manufacturing method further includes:
depositing a carrier transport layer on the epitaxial layer of the semiconductor substrate with the epitaxial layer formed; where
the depositing a quantum dot transport layer on the epitaxial layer includes:
depositing the quantum dot transport layer on the carrier transport layer.

Optionally, the depositing a carrier transport layer on the epitaxial layer includes:
depositing a film layer with a thickness ranging from 1nm to 50nm on the epitaxial layer of the semiconductor substrate with the epitaxial layer formed; and
performing annealing process on the epitaxial layer and the film layer at a temperature ranging from 500°C to 1500°C to form the carrier transport layer.

Optionally, the thermally growing a gate oxide layer on the quantum dot transport layer includes:
thermally growing the gate oxide layer on the quantum dot transport layer at a temperature ranging from 1000°C to 1500°C

Optionally, the method further includes:
forming a metal layer on a side of the semiconductor substrate away from the epitaxial layer and a metal layer on an outer side of the gate oxide layer.

Optionally, the metal layers are formed on the side of the semiconductor substrate away from the epitaxial layer and on the outer side of the gate oxide layer by an electron beam evaporation process or a sputtering process.

Optionally, after the metal layer is formed, the manufacturing method further includes:
performing an annealing process in a nitrogen or argon atmosphere at a temperature ranging from 600°C to 1100°C.

Optionally, after the semiconductor substrate having the epitaxial layer is formed, and before depositing the carrier transport layer on the epitaxial layer, the manufacturing method further includes:
etching the semiconductor substrate with acid or alkali solution to reduce roughness of the semiconductor substrate.

The technical solution provided by the present disclosure introduces a quantum dot transport layer structure below a gate oxide layer to realize an adjustable value of a threshold voltage (Vth), for a reason that the quantum dot transport layer may be used to adjust a height of metal-semiconductor contact potential barrier. Since a height of a potential barrier depends on an appearance of quantum dots, and the appearance of the quantum dots depends on temperature, a shape of the quantum dots may change under a high temperature. According to the disclosure, the temperature during thermal growth of the gate oxide layer may affect the appearance of the quantum dots. In turn, it is possible to control the appearance of the quantum dots by controlling the temperature of the gate oxide layer during its thermal growth. This arrangement may effectively lower the Vth, and then the reduced Vth may not only reduce gate resistance, but also effectively increase electron density of a gate channel to improve a through-current capability of the device. Therefore, the semiconductor device provided by the disclosure may reduce the Vth while ensuring the gate electrode reliability.

On the other hand, according to a preferred embodiment of the present disclosure. By introducing a carrier transport layer structure between the quantum dot transport layer and the epitaxial layer, surface scattering of electrons may be inhibited, which may improve gate carrier mobility effectively, and then device reliability may be improved. Therefore, the semiconductor device provided by the present disclosure may reduce the channel gate resistance to effectively improve the channel electron mobility.

The present disclosure also provides a manufacturing method for a semiconductor device. The semiconductor device prepared by the manufacturing method may also reduce the Vth while ensuring the gate reliability, and may reduce the channel gate resistance to effectively improve the channel electron mobility.

### BRIEF DESCRIPTION OF THE DRAWINGS

Accompanying drawings form a part of the present disclosure and serve to provide a further understanding of the disclosure. The illustrative embodiments of the disclosure and the description thereof are used to explain the disclosure and do not constitute an undue limitation on the disclosure. In the accompanying drawings:
FIG. 1 is a structural schematic diagram of a semiconductor device according to an embodiment of the present disclosure.
FIG. 2 is a structural schematic diagram of another semiconductor device according to an embodiment of the present disclosure.
FIG. 3 is a structural schematic diagram of still another semiconductor device according to an embodiment o f the present disclosure.
FIG. 4 is a structural schematic diagram of yet still another semiconductor device according to an embodiment of the present disclosure.

### DETAILED DESCRIPTION OF THE EMBODIMENTS

It should be noted that the embodiments and features of the embodiments in the present disclosure may be combined with each other without conflict. The present disclosure will now be described in detail with reference to the accompanying drawings and embodiments.

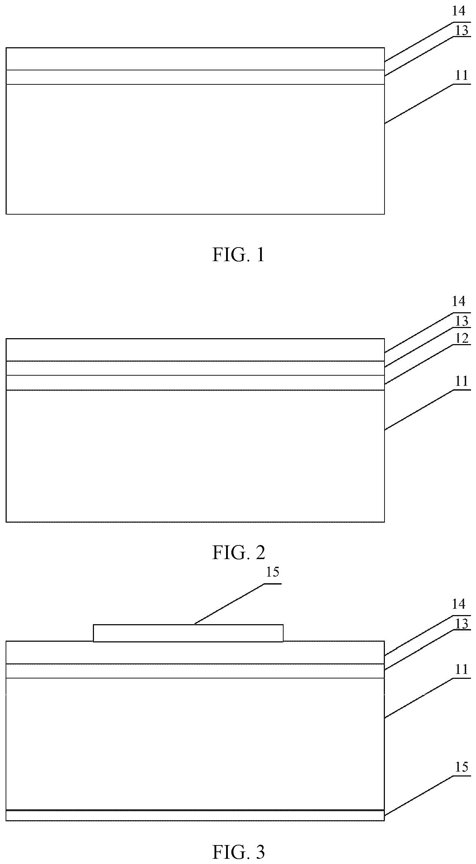

FIG. 1 is a structural schematic diagram of a semiconductor device according to an embodiment of the present disclosure. As shown in FIG. 1, this embodiment provides a gate structure of a semiconductor device, including, from top to bottom, a gate oxide layer 14, a quantum dot transport layer 13, and a semiconductor substrate 11 on which an epitaxial layer is grown, where the quantum dot transport layer 13 may be grown on the epitaxial layer of the semiconductor substrate 11.

It should be noted that the semiconductor device in this embodiment is preferably a SiC MOSFET. Material of the semiconductor substrate 11 may be SiC, and the semiconductor substrate 11 may be a SiC substrate. Preferably, the semiconductor substrate may be an N-type SiC substrate, and material of the quantum dot transport layer 13 may be GaN. A specific structure of the quantum dot transport layer 13 may preferably be a nanowire structure, namely, a one-dimensional quantum dot transmission structure.

The gate oxide layer 14 is disposed on the quantum dot transport layer 13. Preferably, material of the gate oxide layer 14 is preferably SiO₂ and a thickness of the gate oxide layer 14 ranges from 1nm to 50 nm, which may be, for example, 1 nm, 25 nm, 50nm and etc.

According to this arrangement, the quantum dot transport layer 13 is introduced below the gate oxide layer 14 to realize an adjustable value of a threshold voltage (Vth), for a reason that the quantum dot transport layer 13 may be used to adjust a height of metal-semiconductor contact potential barrier. Since a height of a potential barrier depends on an appearance of quantum dots, and the appearance of the quantum dots depends on temperature, a shape of the quantum dots may change under a high temperature. According to the disclosure, the temperature during thermal growth of the gate oxide layer 14 may affect the appearance of the quantum dots. In turn, it is possible to control the appearance of the quantum dots by controlling the temperature of the gate oxide layer 14 during its thermal growth. This arrangement may effectively lower the Vth, and then the reduced Vth may not only reduce gate resistance, but also effectively increase electron density of the gate channel to improve a through-current capability of the device.

As shown in FIG. 2, in an alternative embodiment of the present disclosure, a two-dimensional film material may be deposited on the epitaxial layer of the N-type SiC substrate by a deposition technique, which is namely a carrier transport layer 12. Preferably, the carrier transport layer 12 may be a plane film layer with a thickness ranging from 1nm to 50 nm, such as 1 nm, 25 nm or 50 nm. And then the quantum dot transport layer 13 may be formed on the carrier transport layer 12.

In the embodiment of the present disclosure, a lattice matching degree between the carrier transport layer and the semiconductor substrate is greater than a preset matching degree. In practical application, the lattice matching degree is also referred to as a lattice constant matching degree, and is used to determine whether space between crystal planes of two materials is close or equal. Therefore, the carrier transport layer and the semiconductor substrate may be completely interfaced when the crystal lattice is solidified. As the lattice matching degree between SiC and SiO₂ is poor, directly disposing SiO₂ on a SiC substrate may result in a poor device performance ultimately. In an embodiment of the present disclosure, material of the semiconductor substrate includes SiC, and accordingly material of the carrier transport layer may be any one of MoS₂, BN, Bi₂Te₃ and Bi₂Se₃ , so that there would be a high lattice matching degree between the semiconductor substrate and the carrier transport layer.

The two-dimensional film refers to a thin plane film structure. According to this arrangement, by introducing a structure of the carrier transport layer 12 between the quantum dot transport layer 13 and the epitaxial layer, surface scattering of electrons may be inhibited which may improve gate carrier mobility effectively, and then device reliability may be improved. Therefore, the gate electrode structure of the SiC MOSFET device provided by the disclosure may reduce a threshold voltage (Vth) while ensuring the gate electrode reliability and reduce the channel gate resistance to effectively improve the channel electron mobility.

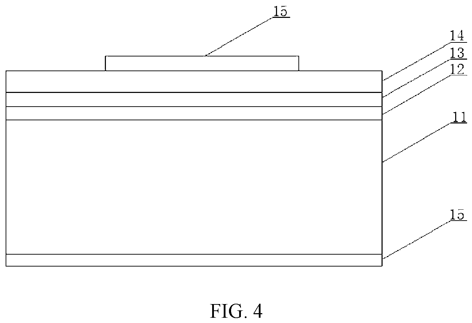

Moreover, the gate electrode structure of the SiC MOSFET device provided by the embodiment may further include metal layers. Referring to FIG. 3, on the basis of the embodiment shown in FIG. 1, metal layers 15 are added. Referring to FIG. 4, on the basis of the embodiment shown in FIG. 2, metal layers 15 are formed on an outer side of the semiconductor substrate 11, that is, on a side away from the epitaxial layer 11, and on an outer side of the gate oxide layer 14. Preferably, a thickness of the metal layer 15 ranges from 1µm to 5 µm, such as 1 µm, 3 µm, or 5 µm. The metal layer 15 may be used to realize a conductive connection to an external electronic device.

An embodiment also provides a manufacturing method for a semiconductor device, including:
forming a semiconductor substrate 11 with an epitaxial layer by an epitaxial growth process;
depositing a quantum dot transport layer 13 on the epitaxial layer; and
thermally growing a gate oxide layer 14 on the quantum dot transport layer 13.

In a preferred embodiment, the manufacturing method for the semiconductor device further includes:
depositing a carrier transport layer 12 on the epitaxial layer, the quantum dot transport layer 13 being deposited on the carrier transport layer 12.

Therein, the substrate with an epitaxial layer may be formed by an epitaxial growth process, for example, a substrate may be formed by lightly doped N-type (nitrogen-doped) SiC epitaxial growth. It should be noted that surface of a gate semiconductor has a particularly large influence on characteristics of a gate electrode. The rougher the gate surface is, the more severe the surface scattering of electrons in channel is, and the lower the mobility of the electrons in channel is. In order to obtain a good surface, it is necessary to perform acid or alkaline etching on the surface of the substrate to improve roughness of the surface of the semiconductor substrate 11.

In the step of depositing a carrier transport layer 12 on the epitaxial layer, a two-dimensional film material with a thickness ranging from 1nm to 50nm may be deposited on an N-type epitaxial layer, and the two-dimensional film material may be any one of Mo S₂, BN, Bi₂Te₃ and Bi₂Se₃. Meanwhile, interface characteristics of the carrier transport layer 12 and the epitaxial layer may be improved by performing annealing process at a temperature ranging from 500°C to 1500°C. Since the lattice matching degree of SiC and SiO₂ is poor, the introduction of the carrier transport layer 12 may effectively improve the problem.

In the step of depositing the quantum dot transport layer 13 on the carrier transport layer 12, a one-dimensional quantum dot transport layer 13 (namely, a quantum dot transport layer with a nanowire structure), may be deposited on the carrier transport layer 12 may be deposited on the carrier transport layer 12 at a temperature ranging from 500°C to 700°Cby metal organic chemical vapor deposition (MOCVD). A specific material of the quantum dot transport layer 13 may be GaN. The introduction of the quantum dot transport layer 13 may reduce contact potential barrier between the gate electrode and the semiconductor, thereby reducing a threshold voltage (Vth) of the device. As a result, electron density of the channel below the gate electrode may be increased, and through-current capability of the device may be improved.

In the step of thermally growing the gate oxide layer 14 on the quantum dot transport layer 13, on the one-dimensional quantum dot transport layer, the gate oxide layer 14 with a thickness ranging between 1-50nm is thermally grown at a temperature ranging from 1000°C to 1500°C. Meanwhile, high-temperature may change the appearance of the quantum dot transport layer. Accordingly, in the embodiment, the appearance of the quantum dots may be controlled by controlling the temperature at which the gate oxide layer 14 is thermally grown. In this way, the Vth may be effectively lowered, and the reduced Vth may not only reduce the gate resistance, but also effectively increase the electron density of the gate electrode channel, thereby improving the through-current capability of the device.

In addition, according to the manufacturing method for the semiconductor device provided by the present embodiment, metal layers 15 may be formed on an outer side of the semiconductor substrate 11 and on an outer side of the gate oxide layer 14. In the step of forming the metal layer 15, the metal layer 15 may be deposited by electron beam evaporating or sputtering to form the metal layer 15 with a thickness ranging from 1µm to 5µm. And then an annealing process is performed in a nitrogen or argon atmosphere at a high temperature ranging from 600°C to 1100°C to form a good ohmic contact of a collector electrode on the back.

Thus, according to the manufacturing method of the semiconductor device provided by the present embodiment, the semiconductor device manufactured by the method may reduce the Vth while ensuring the reliability of the gate electrode, and may reduce the channel gate resistance and effectively improve the electron mobility of the channel.

It should be noted that the terminology used herein is for the purpose of describing particular embodiments only and is not intended to limit the exemplary embodiments according to the present disclosure. As used herein, the singular forms are also intended to include the plural forms unless the context clearly dictates otherwise, and it is to be understood that when the terms "comprise" and/or "include" are used in this specification, they indicate the presence of features, steps, operations, devices, components, and/or combinations thereof.

Unless specifically stated otherwise, relative arrangements, numerical expressions, and numerical values of the components and steps set forth in these embodiments do not limit the scope of the present disclosure. Meanwhile, it should be understood that, for ease of description, the dimensions of the various parts shown in the drawings are not drawn to actual scale. Techniques, methods, and devices known to those skilled in the art may not be discussed in detail, but such techniques, methods, and devices should, where appropriate, be considered as part of the specification. In all examples shown and discussed herein, any specific value is to be interpreted as illustrative only and not as limiting. Thus, other examples of exemplary embodiments may have different values. It should be noted that like reference numerals and letters denote like terms in the following figures, and therefore, once an item is defined in one figure, no further discussion thereof is required in subsequent figures.

In the description of the disclosure, it should be understood that the orientation or positional relationship indicated by locative words such as "front, back, up, down, left, right", "horizontal, vertical, horizontal" and "top, bottom" are usually based on the orientation or positional relationship shown in the drawings, only for convenience and simplification of the description of this disclosure. Without any explanation to the contrary, these locative words do not indicate or imply that the device or element referred to must have a specific location or be constructed and operated in a specific location, so they cannot be understood as a limitation on the scope of protection of the disclosure. The words "inside and outside" refer to the inside and outside relative to the outline of each component itself.

In order to facilitate description, spatial relative terms such as "above", "above", "on the upper surface of", "above", etc. may be used here to describe the spatial positional relationship between one device or feature and other devices or features as shown in the figure. It should be understood that spatial relative terms are intended to include different orientations in use or operation other than the orientation of the device depicted in accompanying drawings. If the devices in the accompanying drawings are inverted, for example, the devices described as "above" or "above" other devices or structures will be positioned as "below" or "under" other devices or structures. Thus, the exemplary term "above" may include two orientations of "above" and "below". The device may also be positioned in other different ways (rotated by 90 degrees or in other orientations), and the spatial relative description used here is explained accordingly.

In addition, it should be noted that the use of words such as "first" and "second" to define parts is only for the convenience of distinguishing the corresponding parts. Unless otherwise stated, the above words have no special meaning, so they cannot be understood as limiting the scope of protection of the disclosure.

The above are only the preferred embodiments of the present disclosure, and it is not intended to limit the present disclosure. For those skilled in the art, the present disclosure may have various modifications and changes. Any modification, equivalent substitution, improvement, etc. made within the spirit and principle of this disclosure shall be included in the scope of protection of the disclosure.

## Claims

1. A semiconductor device, comprising:
a semiconductor substrate, wherein an epitaxial layer is grown on a surface of the semiconductor substrate;
a quantum dot transport layer formed on the epitaxial layer; and
a gate oxide layer formed on the quantum dot transport layer.

2. The semiconductor device according to claim 1, wherein material of the quantum dot transport layer comprises GaN.

3. The semiconductor device according to claim 1, wherein a structure of the quantum dot transport layer is a nanowire structure.

4. The semiconductor device according to claim 1, wherein the semiconductor substrate comprises an N-type SiC substrate.

5. The semiconductor device according to any one of claims 1 to 4, further comprising a carrier transport layer formed between the quantum dot transport layer and the epitaxial layer.

6. The semiconductor device according to claim 5, wherein a lattice matching degree between the carrier transport layer and the semiconductor substrate is greater than a preset matching degree.

7. The semiconductor device according to claim 5, wherein material of the semiconductor substrate comprises SiC, and material of the carrier transport layer comprises: MoS₂, BN, Bi₂Te₃ or Bi₂Se₃.

8. The semiconductor device according to claim 5, wherein the carrier transport layer is a plane film layer and a thickness of the planar film layer ranges from 1nm to 50 nm.

9. The semiconductor device according to claim 1, further comprising a metal layer formed on a side of the semiconductor substrate away from the epitaxial layer and a metal layer formed on an outer side of the gate oxide layer.

10. A manufacturing method for a semiconductor device, comprising:
forming a semiconductor substrate with an epitaxial layer by an epitaxial growth process;
depositing a quantum dot transport layer on the epitaxial layer; and
thermally growing a gate oxide layer on the quantum dot transport layer.

11. The manufacturing method of the semiconductor device according to claim 10, wherein the depositing a quantum dot transport layer on the epitaxial layer comprises:
depositing the quantum dot transport layer at a temperature ranging from 500°C to 700°C by metal organic chemical vapor deposition (MOCVD).

12. The manufacturing method of the semiconductor device according to claim 10 or 11, further comprising:
depositing a carrier transport layer on the epitaxial layer of the semiconductor substrate with the epitaxial layer formed; wherein
the depositing a quantum dot transport layer on the epitaxial layer comprises: depositing the quantum dot transport layer on the carrier transport layer.

13. The manufacturing method of the semiconductor device according to claim 12, wherein the depositing a carrier transport layer on the epitaxial layer comprises:
depositing a film layer with a thickness ranging from 1nm to 50nm on the epitaxial layer of the semiconductor substrate with the epitaxial layer formed; and
performing annealing process on the epitaxial layer and the film layer at a temperature ranging from 500°C to 1500°C to form the carrier transport layer.

14. The manufacturing method of semiconductor device according to claim 10, wherein the thermally growing a gate oxide layer on the quantum dot transport layer comprises:
thermally growing the gate oxide layer on the quantum dot transport layer at a temperature ranging from 1000°C to 1500°C.

15. The manufacturing method of the semiconductor device according to claim 10, further comprising:
forming a metal layer on a side of the semiconductor substrate away from the epitaxial layer and a metal layer on an outer side of the gate oxide layer.

16. The manufacturing method of the semiconductor device according to claim 15, wherein the metal layers are formed on the side of the semiconductor substrate away from the epitaxial layer and on the outer side of the gate oxide layer by an electron beam evaporation process or a sputtering process.

17. The manufacturing method of the semiconductor device according to claim 16, wherein after the metal layer is formed, the manufacturing method further comprises:
performing an annealing process in a nitrogen or argon atmosphere at a temperature ranging from 600°C to 1100°C.

18. The manufacturing method of the semiconductor device according to claim 13, wherein after the semiconductor substrate with the epitaxial layer is formed, and before depositing the carrier transport layer on the epitaxial layer, the manufacturing method further comprises:
etching the semiconductor substrate with acid or alkali solution to reduce roughness of the semiconductor substrate.
